# FASCICULE DE BREVET EUROPEEN

(11) **EP 3 235 037 B1**
(45) Date de publication et mention de la délivrance du brevet: **14.10.2020**
(21) Numéro de dépôt: 15813055.9
(22) Date de dépôt: 17.12.2015
(51) Int. Cl.: H01M 8/04492, G01R 31/36, H01M 8/04537

(54) **SYSTÈME DE MESURE DE L'HYGROMÉTRIE D'UNE MEMBRANE ÉCHANGEUSE D'IONS DANS UNE PILE À COMBUSTIBLE**
SYSTEM ZUR MESSUNG DER HYGROMETRIE EINER IONENAUSTAUSCHMEMBRAN IN EINER BRENNSTOFFZELLE
SYSTEM FOR MEASURING THE HYGROMETRY OF AN ION EXCHANGE MEMBRANE IN A FUEL CELL

(30) Priorité: 19.12.2014 FR 1462904
(43) Date de publication de la demande: 25.10.2017
(73) Titulaire: Compagnie Générale des Etablissements Michelin, 63000 Clermont-Ferrand (FR)
(72) Inventeur: BRAILLARD, Vincent, 63040 Clermont-Ferrand Cedex 9 (FR); PAGANELLI, Gino, 63040 Clermont-Ferrand Cedex 9 (FR)
(74) Mandataire: Roussy, Delphine
(86) Numéro de dépôt international: PCT/EP2015/080172
(87) Numéro de publication internationale: WO 2016/097114

(56) Documents cités:
- WO-A1-02/35677
- WO-A1-2014/046028
- FR-A1- 2 982 374
- US-A1- 2002 196 025
- US-A1- 2011 027 679

## Description

### DOMAINE DE L'INVENTION

La présente invention concerne le domaine des piles à combustible et notamment les systèmes de surveillance de telles piles. Plus particulièrement, elle se rapporte aux dispositifs de mesure de tensions dans les piles à combustible.

Les piles à combustible connaissent un succès grandissant dans de nombreuses applications. Elles intéressent notamment l'industrie automobile dans le cadre du développement des véhicules électriques, puisqu'elles constituent des générateurs d'électricité propres, de poids inférieur aux accumulateurs électrochimiques de type batteries, et présentant un bon rendement.

Dans une pile à combustible, l'électricité est produite par une double réaction chimique : l'oxydation d'un carburant, par exemple de l'hydrogène, sur une électrode, couplée à la réduction d'un comburant, par exemple de l'oxygène, sur une autre électrode. Ainsi, une pile à combustible comporte généralement une anode et une cathode entre lesquelles est disposée une membrane, formant un ensemble d'électrode à membrane, généralement appelé MEA (de l'anglais Membrane Electrode Assembly). Différents types de membranes peuvent être utilisés, et on connaît par exemple des membranes polymères fluorées.

Afin que la réaction chimique puisse se produire, il est nécessaire que la membrane présente une bonne conduction protonique. Or, cette conduction protonique s'améliore quand le degré d'humidité de la membrane augmente. Toutefois, il faut veiller à ce que l'eau ne soit pas non plus en excès, car l'eau liquide peut obstruer le passage du gaz. Il apparaît donc utile, au vu de ces éléments, de pouvoir surveiller l'humidité de la membrane au cours du fonctionnement d'une pile à combustible.

Par ailleurs, lors de l'utilisation de piles à combustible dans des conditions de températures très froides, on a constaté qu'il était utile d'effectuer un séchage de la membrane lors de l'extinction de la pile à combustible, afin de faciliter un démarrage à froid ultérieur. En effet, la membrane constitue le seul « refuge » dans l'empilement où l'eau ne gèle pas lorsque la pile est dans un environnement très froid. Au contact de tous les autres composants du cœur de pile, l'eau gèlerait immédiatement et formerait des bouchons qui empêcheraient le fonctionnement de la pile. Pour pouvoir profiter de cet accumulateur il faut qu'il soit en mesure d'absorber de l'eau (la membrane a une capacité d'absorption d'eau limitée appelée « water absorption capability [mg/cm2] », d'où la nécessité de sécher la membrane avant le démarrage à froid. Il est donc utile de pouvoir également mesurer l'humidité de la membrane après extinction de la pile à combustible.

On connaît, dans l'état de la technique, différents moyens pour mesurer l'hygrométrie de la pile à combustible. Toutefois, ces moyens connus sont généralement indépendants de toute autre fonctionnalité, et nécessite donc une installation additionnelle dans un système à pile à combustible, qui comporte déjà un grand nombre de dispositifs de mesure et/ou gestion.

La présente invention vise donc à fournir un système de mesure qui permette de remédier à cet inconvénient.

### BREVE DESCRIPTION DE L'INVENTION

L'invention est définie par les revendications. L'invention concerne ainsi un système de mesure de l'hygrométrie d'une membrane échangeuse d'ions dans une pile à combustible comportant N cellules électrochimiques séparées par des plaques bipolaires, où N est un entier naturel, le système comprenant :
- Un générateur de courant permettant d'appliquer un courant à la pile à combustible,
- Un dispositif de mesure de tensions des cellules, et
- Des moyens pour déterminer l'impédance d'une membrane en fonction d'une ondulation de tension mesurée par le dispositif de mesure aux bornes de la cellule correspondante lors d'une application du courant par le générateur de courant, ces moyens étant installés dans le dispositif de mesure de tensions des cellules.

La membrane d'une pile à combustible, notamment de type PEMFC, est une couche de polymère solide. Or, on sait que plus un solide est humide, plus son impédance est faible. Par conséquent, en faisant passer un courant dans la membrane et en mesurant les ondulations de tension qui en découlent, on est capable de déterminer la résistance de la membrane et donc son hygrométrie.

Par ailleurs, le fait d'installer les moyens de détermination de l'impédance directement dans le dispositif de mesure de tensions des cellules permet de simplifier l'installation, et permet ainsi d'embarquer plusieurs fonctions dans un même système, sans alourdir la construction de système de pile à combustible.

Dans une réalisation avantageuse, le générateur de courant applique un courant à une fréquence de 1000 Hertz. Dans ce mode de réalisation, l'hygrométrie de la membrane sera suffisamment faible si la résistance de la membrane est de l'ordre de 2.5 milliOhms par cellule de 200cm2 de surface active, soit 40 milliOhms pour un empilement de 16 cellules.

L'invention concerne ainsi un dispositif de mesure de tensions de cellules dans une pile à combustible comportant N cellules électrochimiques séparées par des plaques bipolaires, où N est un entier naturel, le système comprenant :
- au moins deux modules de mesure de tension, chaque module étant capable de mesurer M tensions sur un ensemble de cellules contigües de la pile à combustible, où M est un entier naturel inférieur ou égal à N/2, le groupe de cellules mesurées par le premier module étant adjacent au groupe de cellules mesurées par le deuxième module,
- un calculateur électronique, et
- un bus de communication filaire reliant en série les au moins deux dispositifs de mesure au calculateur,
chacun des modules de mesure comprenant :
- des moyens mécaniques de fixation du module sur la pile à combustible,
- des moyens électroniques de mesure de tension,
- des moyens électriques de connexion des plaques bipolaires à au moins un moyen électronique de mesure de tension,
- des moyens de connexion des moyens électroniques de mesure de tension au bus de communication,

En outre, les moyens mécaniques de fixation du module sur la pile à combustible et les moyens électriques de connexion seront confondus. Ainsi, ces moyens comporteront des cosses, par exemple des cosses femelles de type Faston®, permettant d'effectuer à la fois une connexion mécanique et électrique. Ces cosses femelles comportent deux parties métalliques agencées pour enserrer des ergots métalliques formés sur les plaques bipolaires de la pile, et permettant de réaliser la connexion.

Dans une réalisation particulière de l'invention, chaque moyen électronique de mesure de tension mesure les tensions de deux cellules adjacentes. En effet, étant donné la faible épaisseur des cellules électrochimiques d'une pile à combustible, il s'avère peu ergonomique d'installer des moyens pour mesurer les tensions individuelles de chaque cellule. Par ailleurs, on a constaté que la sensibilité des moyens de mesure était suffisante pour qu'une mesure effectuée sur deux cellules permette de rendre compte de l'état de chacune des cellules. Ainsi, dans un mode de réalisation particulier, un module effectue huit mesures de tension pour un ensemble de seize cellules.

Dans une réalisation particulière de l'invention, le bus de communication filaire est un bus série de type CAN® (Control Area Network), présentant des caractéristiques de robustesse utiles dans le cadre d'un dispositif tel que celui de la présente invention. Dans une autre réalisation particulière, un bus de type I2C est utilisé.

Par ailleurs, dans une autre réalisation particulière de l'invention, le dispositif de mesure comprend au moins un dispositif d'isolation galvanique entre le bus de communication filaire et la pile à combustible. Un tel dispositif comprend, par exemple, un optocoupleur. En effet, la pile à combustible est constituée de cellules connectées en série ; en fonction de sa position sur la pile à combustible, chaque module de mesure se trouve donc à un potentiel différent par rapport à la polarité négative de la pile à combustible. Il convient donc de réaliser une isolation galvanique entre les moyens de mesure et le bus de communication commun.

Dans une autre réalisation particulière de l'invention, chaque module de mesure de tension comporte une adresse, ou codage, différent des autres modules. En effet, ainsi qu'expliqué ultérieurement, ceci permet au calculateur électronique d'adresser les requêtes par lesquelles des mesures sont demandées aux différents modules.

Le calculateur électronique est utilisé pour gérer les mesures effectuées par le dispositif. Pour cela, il communique avec les modules via le bus de communication filaire, et reçoit les résultats des mesures par le même biais. Dans la suite de la demande, ce calculateur sera dénommé contrôleur, sans toutefois restreindre la portée du terme à un type spécifique de composant.

### BREVE DESCRIPTION DES FIGURES

D'autres objectifs et avantages de l'invention apparaîtront clairement dans la description qui va suivre d'un mode de réalisation préféré mais non limitatif, illustré par les figures suivantes dans lesquelles :
- la figure 1 représente un schéma fonctionnel d'un module utilisé dans le cadre d'un dispositif selon l'invention,
- la figure 2 représente un dispositif selon l'invention comportant quatre modules de mesure.

### DESCRIPTION DU MEILLEUR MODE DE REALISATION DE L'INVENTION

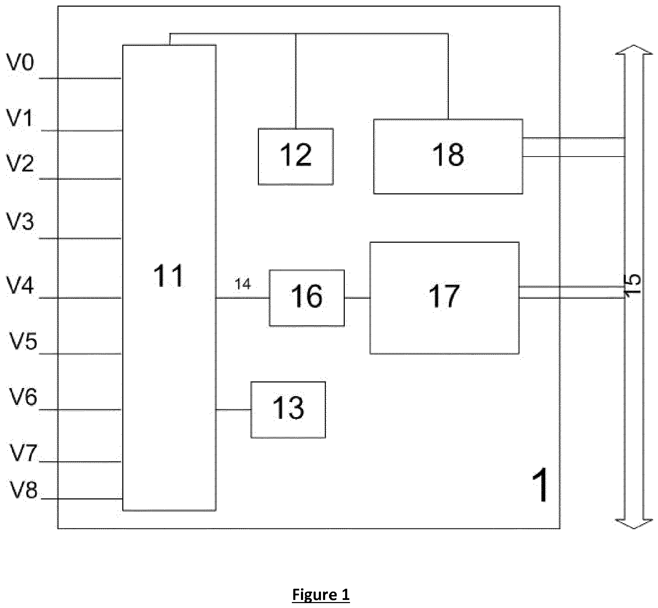

La figure 1 montre un exemple d'architecture fonctionnelle d'un dispositif de mesure de tension mis en œuvre dans un système selon l'invention.

Le module 1 est connecté à neuf plaques bipolaires, ce qui permet de procéder à la mesure de neufs potentiels V0 à V8. Ces mesures sont effectuées par des convertisseurs analogique / numérique 11. Ce convertisseur est relié à une valeur de référence 12 égale par exemple à 0,5 volts, permettant de comparer les mesures transmises par les montages 10. Les huit tensions présentent aux bornes des cellules mesurées est ensuite calculée par le microcontrôleur 16 par différenciation entre 2 mesures de tension successives.

Le convertisseur analogique / numérique 11 ne peut convertir que des tensions positives. Or, il est souhaitable, dans un mode de réalisation de l'invention, de pouvoir mesurer également des tensions négatives, qui permettent de détecter une inversion d'une cellule, notamment dû à une sous-alimentation en hydrogène. Pour remédier à cela, le convertisseur 11 est également relié à un dispositif 13 permettant l'application d'une tension de décalage sur les tensions mesurées, avant la conversion.

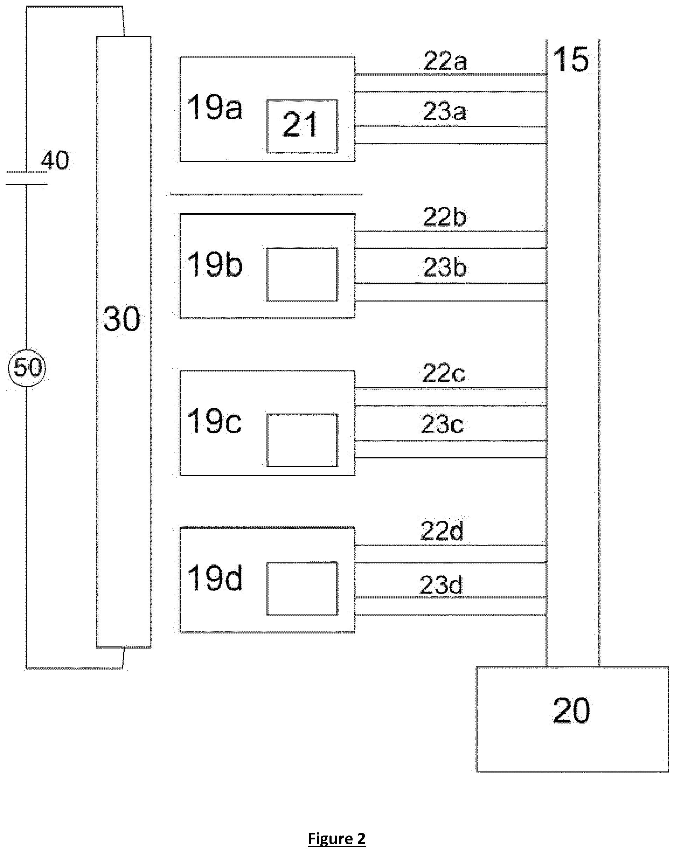

Une fois la conversion d'une mesure effectuée, le résultat est transmis à un bus de données 14. Ce bus est, par exemple, un bus série de type I2C (Inter Integrated Circuit), ou de type CAN®. Ce bus de données 14 achemine les données à un second bus de données 15, qui achemine ensuite les données jusqu'à un contrôleur général 20 (voir Figure 2). Dans le cas où les bus 14 et 15 ne sont pas de même type, il est utile de prévoir un microcontrôleur 16, permettant de convertir les données sous un format supporté par le bus 15. Par ailleurs, afin d'éviter que les hautes tensions présentes au niveau de la pile à combustible ne se propagent sur le bus 15 et endommagent certains composants, il est utile de disposer d'un dispositif d'isolation galvanique 17, par exemple un optocoupleur.

L'ensemble du module 1 est alimenté par le bus 15. A cet effet, un convertisseur tension/tension 18 est installé dans le module, et relié aux principaux composants. Ce convertisseur comprend également, dans une réalisation préférentielle, un dispositif d'isolation galvanique pour éviter le problème précédemment mentionné.

La figure 2 montre un exemple de réalisation d'un système selon l'invention, mettant en œuvre plusieurs dispositifs de mesure conforme à celui de la figure 1, ces dispositifs étant ci-après appelés « modules ».

Ce dispositif comprend quatre modules 19a, 19b, 19c et 19d. Chacun des modules est connecté au bus 15 qui les relie au contrôleur 20. Le nombre de modules est donné ici à titre d'exemple et n'est pas limitatif. Chaque module est relié à 8 cellules de la pile à combustible 30. Ces liaisons ne sont pas représentées sur la figure par souci de simplification. Un dispositif à quatre modules permet, dans le cas où on utilise un convertisseur à huit entrées, de mesurer trente-deux tensions. Il est donc utilisable sur une pile à soixante-quatre cellules dans le cas où les tensions de cellules sont mesurées par groupe de deux cellules. Chacun des modules dispose d'une adresse 21 permettant de le distinguer. Par exemple, cette adresse est codée sur trois bits à trois états et est physiquement inscrite sur chaque module par l'utilisation de points de soudure permettant d'effectuer des liaisons électriques représentant chacun des bits.

Le contrôleur 20 est l'organe qui gère le fonctionnement du dispositif de mesure, et notamment qui commande les mesures. En effet, les mesures de tension ne sont pas transmises en permanence au contrôleur, mais uniquement sur requête.

En l'absence de requête, les modules prélèvent sur le bus 15, via les liaisons correspondantes 22a, 22b, 22c et 22d, uniquement un courant de maintien leur permettant de recevoir les requêtes et de déterminer s'ils sont concernés. En revanche, en l'absence de requête, le convertisseur 11 n'est pas activé, donc aucune conversion n'est effectuée

Lorsqu'une mesure est nécessaire, le contrôleur 20 envoie dans un premier temps une requête sur le bus, comprenant l'adresse du module et la position de la cellule dont on souhaite recevoir la tension. A réception de la requête, le module adressé sort de son état de veille, et prélève un courant supérieur sur le bus 15.

Il procède alors à une lecture de la valeur précédemment convertie et stockée au niveau du convertisseur 11, puis déclenche une nouvelle conversion, destinée à être utilisée lors d'une requête ultérieure. La valeur lue est alors transférée sur le bus 15 via la liaison correspondante parmi les liaisons 23a à 23d, puis communiquée au contrôleur 20.

Le contrôleur 20 de la pile est ainsi en capacité, en fonction des mesures reçues, de déterminer que les tensions ne sont pas figées, et qu'elles ne se situent pas en dehors du domaine de fonctionnement classique. Si un défaut est détecté, il peut être utile d'arrêter la pile pour éviter tout dysfonctionnement dangereux.

Un dispositif selon l'invention répond donc bien aux exigences de simplicité et de fiabilité requises. En effet, le bus 15 sert à la fois à la communication des données et à l'alimentation des modules, ce qui permet de poursuivre les mesures même en cas de dysfonctionnements de la pile.

Le système montré en figure 2 comprend un générateur de courant 1 kHz, référencé 50, pour la mesure d'impédance. Ce courant est appliqué aux polarités de puissance de l'empilement 30. On suppose ici qu'il s'agit d'un empilement de 16 cellules. Dans le cas d'empilement plus grand, le générateur de courant est connecté aux polarités extrêmes de l'empilement indépendamment du nombre de module de mesure de tension. Pour découpler le générateur de courant 50 de la tension continue possiblement présente aux bornes de l'empilement 30, qui constitue un générateur de tension, un condensateur 40 est ajouté en série entre le générateur de courant 50 et les polarités de l'empilement 30.

Pour la mesure d'impédance, on s'intéresse à la composante alternative 1000Hz de la tension présente aux bornes des cellules. Le dispositif de mesure de tension doit donc être suffisamment rapide pour mesurer cette ondulation de tension. En pratique il doit être capable de mesurer au moins à la fréquence de 10kHz. L'ondulation de tension induite par le courant de 1kHz injecté aux bornes de l'empilement augmente avec l'impédance. L'impédance est déterminée pour chaque module de mesure de tension par en divisant la composante 1kHz de la tension divisée par la valeur du courant 1kHz injecté. L'impédance totale pour l'empilement est alors calculée par addition de l'impédance indiquée par chaque module. L'ondulation de tension induite par le courant 1kHz est plus sensible et la mesure plus précise lorsque le courant continu produit par l'empilement est faible ou nul. En général cependant le séchage de la pile est réalisé lorsque la pile à combustible est à l'arrêt ou sous faible courant.

Un autre avantage lié à l'utilisation du dispositif de mesure de tension pour déterminer l'impédance est qu'il est possible de déterminer le niveau d'hygrométrie de chaque groupe de 2 cellules puisque les mesures de tensions sont réalisées au niveau de chaque groupe de 2 cellules. Cela peut être avantageux pour déterminer l'homogénéité de l'hygrométrie au sein de l'empilement par rapport à une mesure globale de l'impédance au niveau des polarités de l'empilement comme cela est généralement réalisé mais qui ne donne aucune indication sur l'homogénéité de l'hygrométrie. Ceci est particulièrement avantageux pour les empilements de plusieurs dizaines de cellules pour lesquels une inhomogénéité du niveau d'hygrométrie est susceptible de se produire en raison des pertes de charge dans les manifolds lors du séchage. Il peut aussi être avantageux de fixer un critère d'impédance pour le groupe de 2 cellules le plus humide plutôt que pour l'ensemble de l'empilement. En effet lors d'un démarrage à froid, si l'hygrométrie des membranes n'est pas homogène au sein de l'empilement, les membranes les plus humides risques de devenir le facteur limitant la réussite du démarrage à froid.

Par soucis d'économie, les dispositifs de mesure de tension peuvent ne pas être montés sur la totalité de l'empilement mais uniquement sur les zones les plus sensibles nécessitant une surveillance, en général les extrémités. Dans cette configuration, la mesure d'impédance ne sera réalisée que sur les cellules équipées du dispositif de mesure de tension. Il suffira alors d'adapter au nombre de cellules surveillées le critère d'impédance cible lors du séchage en préparation au démarrage à froid. Par simplicité, le courant 1kHz peut quant à lui être injecté aux bornes de l'empilement et traversera donc toutes les cellules même celles qui ne sont pas surveillées mais cela n'engendre pas de problème particulier.

## Revendications

1. Système de mesure de l'impédance d'une membrane échangeuse d'ions dans une pile à combustible comportant N cellules électrochimiques séparées par des plaques bipolaires, où N est un entier naturel, le système comprenant :
- Un générateur de courant permettant d'appliquer un courant à la pile à combustible,
- Un dispositif de mesure de tensions des cellules, et
- Des moyens pour déterminer l'impédance de la membrane en fonction d'une ondulation de tension mesurée par le dispositif de mesure aux bornes des cellules mesurées lors d'une application du courant par le générateur de courant, ces moyens étant installés dans le dispositif de mesure de tensions des cellules, le système étant **caractérisé en ce que** :
le dispositif de mesure de tensions des cellules comprend :
- au moins deux modules de mesure de tension (19a, 19b, 19c, 19d), chaque module étant capable de mesurer M tensions sur un ensemble de cellules contigües de la pile à combustible (32), où M est un entier naturel inférieur ou égal à N/2, le groupe de cellules mesurées par le premier module étant adjacent au groupe de cellules mesurées par le deuxième module,
- un calculateur électronique, et
- un bus de communication filaire reliant en série les au moins deux modules de mesure au calculateur,
chacun des modules de mesure comprenant :
- des moyens mécaniques de fixation du module sur la pile à combustible (30),
- des moyens électroniques de mesure de tension,
- des moyens électriques de connexion des plaques bipolaires à au moins un moyen électronique de mesure de tension,
- des moyens de connexion des moyens électroniques de mesure de tension au bus de communication,
et les moyens électriques de connexion comportent des cosses capables de servir également de moyens mécaniques de fixation.

2. Système selon la revendication 1, dans lequel le générateur de courant applique un courant à une fréquence de 1000 Hertz.

3. Système de mesure selon la revendication 1 ou 2, dans lequel chaque moyen électronique de mesure de tension mesure les tensions de deux cellules adjacentes.

4. Système de mesure selon l'une des revendications précédentes, dans lequel les moyens électriques de connexion sont agencés pour coopérer avec des ergots métalliques disposés sur les plaques bipolaires.

5. Système de mesure selon l'une des revendications précédentes, comprenant en outre au moins un dispositif d'isolation galvanique entre le bus de communication filaire et la pile à combustible.

6. Système de mesure selon la revendication 5, dans lequel le dispositif d'isolation galvanique comprend un optocoupleur.

7. Système de mesure selon l'une des revendications précédentes, dans lequel chaque module de mesure de tension comporte une adresse différente des autres modules.

8. Système de mesure selon l'une des revendications précédentes, dans lequel M est égal à 8.

## Patentansprüche

1. System zur Messung der Impedanz einer Ionenaustauschmembran in einer Brennstoffzelle, welche N durch Bipolarplatten getrennte elektrochemische Zellen aufweist, wobei N eine natürliche Zahl ist, wobei das System umfasst:
- einen Stromgenerator, der es ermöglicht, einen Strom an die Brennstoffzelle anzulegen,
- eine Vorrichtung zur Messung von Spannungen der Zellen, und
- Mittel zum Bestimmen der Impedanz der Membran in Abhängigkeit von einer Spannungswelligkeit, die von der Messvorrichtung an den Klemmen der Zellen gemessen wird, die bei einem Anlegen des Stroms durch den Stromgenerator gemessen werden, wobei diese Mittel in die Vorrichtung zur Messung von Spannungen der Zellen eingebaut sind, wobei das System **dadurch gekennzeichnet ist, dass**:
die Vorrichtung zur Messung von Spannungen der Zellen umfasst:
- wenigstens zwei Spannungsmessmodule (19a, 19b, 19c, 19d), wobei jedes Modul in der Lage ist, M Spannungen an einer Gesamtheit von aneinander angrenzenden Zellen der Brennstoffzelle (32) zu messen, wobei M eine natürliche Zahl kleiner oder gleich N/2 ist, wobei die Gruppe von durch das erste Modul gemessenen Zellen der Gruppe von durch das zweite Modul gemessenen Zellen benachbart ist,
- einen elektronischen Rechner, und
- einen drahtgebundenen Kommunikationsbus, der die wenigstens zwei Messmodule mit dem Rechner in Reihe verbindet,
wobei jedes der Messmodule umfasst:
- mechanische Mittel zur Befestigung des Moduls an der Brennstoffzelle (30),
- elektronische Mittel zur Spannungsmessung,
- elektrische Mittel zur Verbindung der Bipolarplatten mit wenigstens einem elektronischen Mittel zur Spannungsmessung,
- Mittel zur Verbindung der elektronischen Mittel zur Spannungsmessung mit dem Kommunikationsbus,
und die elektrischen Verbindungsmittel Kabelschuhe aufweisen, welche auch als mechanische Befestigungsmittel dienen können.

2. System nach Anspruch 1, wobei der Stromgenerator einen Strom mit einer Frequenz von 1000 Hertz anlegt.

3. Messsystem nach Anspruch 1 oder 2, wobei jedes elektronische Mittel zur Spannungsmessung die Spannungen von zwei benachbarten Zellen misst.

4. Messsystem nach einem der vorhergehenden Ansprüche, wobei die elektrischen Verbindungsmittel dafür ausgelegt sind, mit Metallstiften zusammenzuwirken, die an den Bipolarplatten angeordnet sind.

5. Messsystem nach einem der vorhergehenden Ansprüche, welches außerdem wenigstens eine Vorrichtung zur galvanischen Trennung zwischen dem drahtgebundenen Kommunikationsbus und der Brennstoffzelle umfasst.

6. Messsystem nach Anspruch 5, wobei die Vorrichtung zur galvanischen Trennung einen Optokoppler umfasst.

7. Messsystem nach einem der vorhergehenden Ansprüche, wobei jedes Spannungsmessmodul eine von den anderen Modulen verschiedene Adresse aufweist.

8. Messsystem nach einem der vorhergehenden Ansprüche, wobei M gleich 8 ist.

## Claims

1. System for measuring the impedance of an ion exchange membrane in a fuel cell stack including N electrochemical cells separated by bipolar plates, where N is a natural integer, the system comprising:
- a current generator allowing a current to be applied to the fuel cell stack;
- a device for measuring voltages of the cells; and
- means for determining the impedance of the membrane according to a voltage ripple measured by the measurement device across the terminals of the measured cells when a current is applied by the current generator, these means being installed in the device for measuring voltages of the cells, the system being **characterised in that**:
the device for measuring voltages of the cells comprises:
- at least two voltage measurement modules (19a, 19b, 19c, 19d), each module being capable of measuring M voltages across a set of contiguous cells of the fuel cell stack (32), where M is a natural integer smaller than or equal to N/2, the group of cells measured by the first module being adjacent to the group of cells measured by the second module;
- an electronic computer; and
- a wired communication bus connecting the at least two measurement modules in series to the computer,
each of the measurement modules comprising:
- mechanical means for fastening the module to the fuel cell stack (30),
- electronic means for measuring voltage;
- electrical means for connecting the bipolar plates to at least one electronic means for measuring voltage;
- means for connecting the electronic means for measuring voltage to the communication bus and
- the electrical connection means include terminals that can also be used as mechanical fastening means.

2. System according to Claim 1, in which the current generator applies a current at a frequency of 1000 hertz.

3. Measurement system according to claim 1 or 2, in which each electronic means for measuring voltage measures the voltages of two adjacent cells.

4. Measurement system according to one of the preceding claims, in which the electrical connection means are arranged so as to interact with metal lugs positioned on the bipolar plates.

5. Measurement system according to one of the preceding claims, additionally comprising at least one galvanic isolation device between the wired communication bus and the fuel cell stack.

6. Measurement system according to Claim 5, in which the galvanic isolation device comprises an optocoupler.

7. Measurement system according to one of the preceding claims, in which each voltage measurement module includes a different address from the other modules.

8. Measurement system according to one of the preceding claims, in which M is equal to 8.
